# EUROPEAN PATENT SPECIFICATION

(11) **EP 0 380 174 B1**
(45) Date of publication and mention of the grant of the patent: **24.06.1998**
(21) Application number: 90200150.2
(22) Date of filing: 22.01.1990
(51) Int. Cl.: G01R 33/54

(54) **Magnetic resonance device with a selectable gain signal amplifier**
Vorrichtung mit magnetischer Resonanz mit einstellbarer Ausbeute eines Signalverstärkers
Appareil à résonance magnétique muni d'un préamplificateur à gain réglable

(30) Priority: 27.01.1989 NL 8900205
(43) Date of publication of application: 01.08.1990
(73) Proprietor: Philips Electronics N.V., 5621 BA Eindhoven (NL)
(72) Inventor: Mehlkopf, Antoon Frans, NL-5656 AA Eindhoven (NL); Den Boef, Johannes Hendrik, NL-5656 AA Eindhoven (NL); Lioen, Rolf Jean Maria, NL-5656 AA Eindhoven (NL)
(74) Representative: Schouten, Marcus Maria

(56) References cited:
- EP-A- 0 209 375
- DE-A- 3 605 162
- GB-A- 2 177 861
- US-A- 4 740 744
- JOURNAL OF MAGNETIC RESONANCE, vol. 78, no. 3, July 1988, pages 574-576,
- Academic Press, Inc., Duluth, MN, US; R.W. DYKSTRA: "An NMR preamplifier modification provides increased proton sensitivity"
- MAGNETIC RESONANCE IN MEDICINE, vol. 6, no. 3, March 1988, pages 287-295, Academic Press, Inc., Duluth, MN, US; V.J. WEDEEN et al.: "Dynamic range compression in MRI by means of a nonlinear gradient pulse"

## Description

The invention relates to a magnetic resonance device for determining a nuclear magnetization distribution in a region of an object, which device comprises:
a) means for generating a steady, uniform magnetic field;
b) means for generating RF electromagnetic radiation in order to generate magnetic resonance signals;
c) means for generating at least one phase encoding gradient magnetic field and a readout gradient field with adjustable gradient directions for influencing the magnetic resonance signals,
d) a detection chain comprising a signal amplifier for detecting, amplifying and sampling the resonance signals during a measuring period, and an analog-to-digital converter which is connected thereto;
e) processing means for processing the sampled resonance signals;
f) control means for controlling at least the means specified sub b) to e), resonance signals being conditioned during a preparation period preceding the measuring period, the control means supplying the means specified sub c) with control signals for adjusting the strength and/or the duration of at least one phase encoding gradient magnetic field so that the integral of the strength of the phase encoding gradient magnetic field over the preparation period is different for each measuring cycle; and
g) adjusting means for adjusting the gain of the amplifier for different resonance signals and means to correct said detected resonance signals for the actual gain, the gain can be selected from a first range or a second range, the values in the first range being lower than these in the second range which are such that the noise factor of the detection chain and the analog-to-digital converter connected thereto is substantially independent of the gain.

A device of this kind is known from British Patent Application No. 2,177,861. In such a magnetic resonance device an N-dimensional data set is recorded, producing the desired image or spectrum after an N-dimensional Fourier transformation. Subsequent to an excitation pulse, various so-called spin echoes can be produced by means of 180° echo pulses or by continuously switching over the measuring gradient field after each measuring period, each of said spin echoes being sampled and producing a set of data for said N-dimensional data set. Because of gradient magnetic fields applied during a preparation period and because of T2 relaxations and/or field inhomogeneities, the intensity of the various resonance signals will differ. The greater the influence of the magnetic gradient fields, field inhomogeneities and the longer the time during which the T2 relaxations can occur, the weaker the magnetic resonance signals will be. In a conventional magnetic resonance system in which a nuclear spin density distribution is determined, a set of data having an index n determined by the time integral over the preparatory gradient magnetic field is obtained by sampling a resonance signal influenced by a preparatory gradient magnetic field during a preparation period. During the successive measuring cycles this integral should have different values which form an arithmetical series n.A. The value of n then ranges, for example from -127, via 0 to + 128 when an image comprises 256 pixels in a direction defined by the gradient of the preparatory gradient magnetic field. The signal to be sampled for the data set 0 (no influencing by a preparatory gradient magnetic field) will have the highest amplitude. The signal amplitudes of the signals to be sampled will decrease very quickly, notably in the present case, as a function of the data set index n (certainly for n > 2). Thus, for the images to be reconstructed the strongest signals are concentrated in the central five data sets (-2 < n < 2) and the signal level for the remaining data sets will be at least a factor ten lower. The adjusting means are used for adapting the receiver chain to varying signal strengths over echo resonance signals for difference MR images in the case of multiple-echo or multiple-slice pulse sequences. The adjusted gain of the receiver chain is the most proper gain in each measurement period. That gain is obtained by calculation of the mean value of the echo signals received in measurement periods with the same ranknumber in a false scan before an actual scan. Within an image the gain remains constant.

A publication by R. Ernst in Journal of Magnetic Resonance, Vol. 4, 1971, pp. 280-296 states that the effect of the quantization noise (the noise added to a signal upon its conversion from analog to digital form) is negligible when the noise level of the signal on the input of the analog-to-digital converter is effectively at least equal to the least-significant bit (= quantization step). When an analog signal is too strong, its amplitude will have to be adapted to the range of an analog-to-digital converter, implying an attenuation of the signal. As a result, the analog-to-digital converter adds noise in the form of quantization noise to the signal. The foregoing can be avoided by taking steps which limit the signal dynamics but which have the drawback that they require additional hardware or additional signal processing. In a magnetic resonance apparatus the receiver is switched over to a lower gain or a higher gain during acquisition of successive echoes in order to drive the analog-to-digital converters to full output. The noise factor of the overall receiver will increase as the receiver gain factor decreases. The signal-to-noise ratio of the images will then be a function of the gain setting of the receiver. In the above case the signal-to-noise ratio will be far from optimum.

In the case of a low gain factor of the receiver which will be selected notably for forming a 3-dimensional image and/or for the imaging of thick slices, the noise factor will be increased by several dB, so that a loss amounting to tens of per cents occurs in the signal-to-noise ratio. The foregoing is a rather universal problem which is becoming more serious because of the increased strength of the signals to be processed due to improvements in the magnetic resonance receiver coils.

It is an object of the invention to provide a magnetic resonance apparatus in which steps are taken to minimize the deterioration of the image quality due to the poorer signal-to-noise ratio upon reception of the resonance signals of strongly varying strength.

To achieve this, a magnetic resonance device in accordance with the invention is characterized in that the adjusting means are arranged so that for high values of said integral the gain is selected as a value in the second range in which a resonance signal received or to be received does not cause overdriving of the detection chain, that the gain is selected as a value in the first range for lower values of said integral and that the gain is switched to a lower value yet should overdriving occur. In such a magnetic resonance device only a limited number of the total number of resonance signals to be measured is measured with a comparatively poor noise factor, most resonance signals being measured and processed with a good noise factor. The amplitude and phase correction can be performed before as well as after the Fourier transformation of the measured resonance signals. A drawback of the proposed magnetic resonance device could consist in that the noise character of the images is no longer uniform in the pseudo time direction. This is due to the fact that the magnetic resonance signals having a poor noise character are situated notably in the range of the better visible low image frequencies and not in the range of the higher image frequencies.

It is to be noted that the relationship between noise factor and gain of an MR detection chain and the insertion of a variable attenuator in the detection chain are known per se from the article "AN NMR Preamplifier Modification Provides Increased Proton Sensitivity" in JMR, Vol. 78, No. 3, July 1988, pp. 574-576. However, the MR system described in said article concerns a system for spectroscopy. No relation is established with imaging MR systems.

The described problem is mitigated in an embodiment of a magnetic resonance device in accordance with the invention in that the processing and control unit is programmed so that measuring cycles executed with a low gain are repeated, the resonance signals of these measuring cycles which have passed the analog-to-digital converter being averaged. In the described magnetic resonance device an equal noise power is obtained per averaged resonance signal as a result of the comparatively more frequent measurement of the signals having a poor noise factor and their averaging. This results in a more uniform noise character of the images.

To achieve this, an embodiment of a magnetic resonance device in accordance with the invention is characterized in that the processing unit comprises an amplifier setting register in which gain settings are stored which are determined on the basis of at least one resonance signal generated during a test measuring cycle executed prior to a measurement.

A preferred embodiment of a magnetic resonance device is characterized in that the amplifier has only two gain settings.

The invention will be described in detail hereinafter with reference to the drawing; therein
Fig. 1 shows a magnetic resonance apparatus in accordance with the invention,
Fig. 2 illustrates a known measuring cycle to be executed by the apparatus shown in Fig. 1, and
Figs. 3a and 3b show gain factor diagrams as a function of the index of a data set to be measured in a measuring cycle.

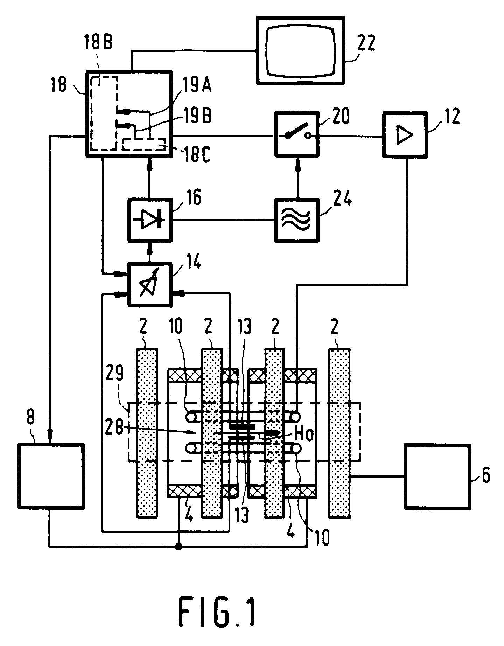

A spin resonance apparatus as shown in Fig. 1 comprises a magnet system 2 for generating a steady magnetic field BO, a magnet system 4 for generating magnetic gradient fields and power supply sources 6 and 8 for the magnet system 2 and the magnet system 4, respectively. An RF magnet coil 10 serves for generating an RF magnetic alternating field, for which purpose it is connected to an RF source 12. For the detection of the resonance signal generated by the RF transmitter field in an object to be examined, use is made of a receiver coil 13; to this end, this coil is connected to a signal amplifier 14. The signal amplifier 14 is connected to a phase-sensitive rectifier 16 which is connected to a central processor unit 18. The central processor unit 18 processes the signals supplied by the phase-sensitive rectifier 16 and calculates therefrom an image of a region of the object which is to be arranged in an examination space 28. Images of this kind can be displayed on a monitor 22. The central processor unit 18 comprises a central control unit 18B which controls a modulator for the RF source 12 and the power supply source 8 for the gradient magnet coils 4 and which adjusts the gain factor of the signal amplifier 14. The amplifier 14 may be actively controlled or may consist of a fixed amplifier comprising an adjustable attenuator in the amplification path. An RF oscillator 24 controls the modulator 20 as well as the phase-sensitive rectifier 16 which processes the measuring signals. The transmitter coil 10 which is arranged within the magnet systems 2 and 4 encloses an examination space 28 which is large enough to accommodate a patient to be examined in the case of a magnetic resonance device for medical diagnostic purposes. Thus, a steady magnetic field BO, a gradient magnetic field for slice selection and a spatially uniform RF alternating field can be generated within the examination space 28. After the generating of an RF magnetic field, the RF coil 10 will be quickly deactivated because subsequently the resonance signal generated must be detected, for example by means of the detection coil 12.

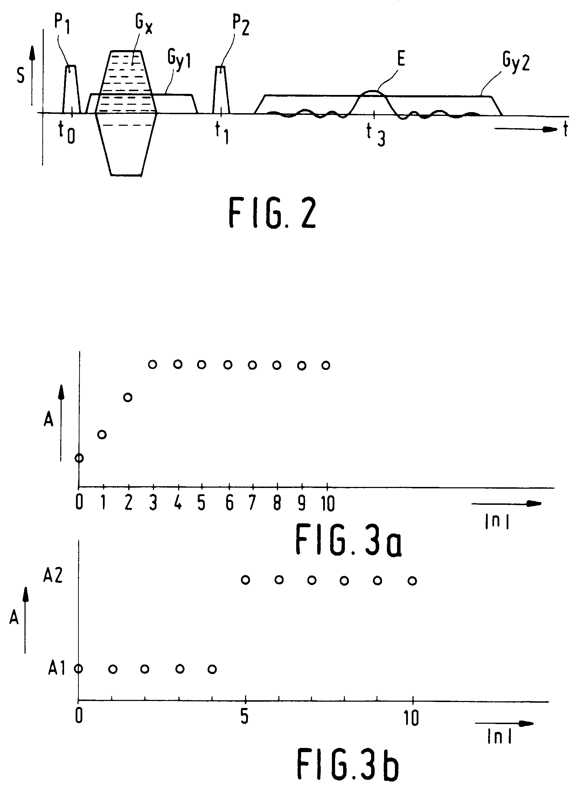

The invention can best be illustrated on the basis of a frequently occurring simple measuring cycle which is diagrammatically shown in Fig. 2. Fig. 2 shows various signals as a function of time which occurs during this measuring cycle. The amplitude ratio of these signals is not shown in proportion in the amplitude direction. The measuring cycle commences with a 90° pulse P1 at the instant t0 which is followed at the instant t1 by a second RF pulse P2, being a 180° pulse, thus generating a spin echo signal E whose centre will be situated at the instant t3. The interval between t0 and t1 is equal to the interval between t1 and t3. Between the RF pulses P1 and P2 usually two gradient fields, i.e. Gx and Gy1 are applied and during a sampling period after the RF pulse P2 a measuring gradient magnetic field Gy2 is applied. The gradient magnetic fields Gy1 and Gy2 are constant for each measuring cycle. As is known, the integral over the time t0-t1 of the gradient field Gx has a different value for each measuring cycle. For the echo signals for which this integral has a value zero or a comparatively low value, the echo signal E will exhibit a comparatively high amplitude. The integral of the gradient field Gx over the period t0-t1 in the successive measuring cycles is stepwise varied, the step size of said integral being the same for the various measuring cycles. When the integral has the value zero, the data set having the index 0 is measured. When the integral has the value of a first step which may be negative or positive, as indicated in Fig. 2, the data set having an index 1 or -1 is measured. When said integral over the gradient field Gx amounts to n steps, the data set having an index n is measured. In an embodiment of the magnetic resonance device in accordance with the invention the gain of the signal amplifier 14 is stepwise varied, under the control of the control unit 18B, in dependence of the absolute value of the index number n as shown in Fig. 3. For the index 0 the gain A is lowest, it being larger each time for the indices |1| and |2| and being constant for the indices |n| ≥ 3. This is because in the present embodiment for the index number 3 a setting of the signal amplifier 14 is obtained where the signal noise of the signal measured has become substantially independent of the effect of the quantizing of the measured signal upon conversion by the ADC in the receiver chain. The index-dependent adjustment of the signal amplifier 14 can be implemented in various ways. For example, different settings of the signal amplifier 14 can be stored in a table, the type of measurement, such as 3-dimensional multiple slice or single slice, the set of parameters of RF pulses to be used for the type of measurement, gradient fields to be applied, etc. and a parameter in the form of an estimate of the object in the examination space being used for selecting the gain factor for the various data sets to be measured which factor is adjusted under the control of the control unit 18B.

A second, more practical implementation is the following. Some test measurements are performed on the object arranged in the examination space 28, these data sets are then measured for which the signal strengths of the resonance signal to be generated are highest. In dependence thereof, gain factors can be determined on the basis of the data set measured, said factors being stored in a table and, as soon as the actual measurement commences, the appropriate gain factor is read from the table in order to adjust the signal amplifier 14 during the execution of a measuring cycle with the relevant data set index number.

A further possibility of estimating the amplitudes to be expected during the successive measurements of resonance signals in consists of a single test measurement during which no preparatory gradient magnetic field is applied. The resonance signal is generated, for example by means of a spin echo method and is sampled in the presence of a measuring gradient magnetic field. If in the gradient direction of the measuring gradient magnetic field the object has the same type of properties (type(s) of matter and distributions thereof) as in the preparatory gradient magnetic field direction, the signal sample associated with the image frequency |kx| = 1; |kx| = 2 etc. offers a suitable estimate of amplitudes to be expected for the data sets having the index numbers 1 and -1; 2 and -2; etc.

Evidently, it is also possible to omit the test measurements and to check during each measurement whether the generated amplitudes are too high to be processed via the ADC. If this is the case, the measurement is repeated, the signal amplifier then having a lower gain setting or an attenuator connected to the signal amplifier having a higher attenuation. The foregoing is attractive notably if the gain of the resonance signal has only two values: A1 and A2 as shown in Fig. 3b.

The foregoing means that in the present example the measuring cycles having an index |n| ≤ 5 are repeated and all measuring cycles for which |n| ≥ 5 are not repeated. Furthermore, an analog-to-digital converter (ADC) 18C should apply not only the digitized resonance signal via the connection 19A but also an overflow signal (in a case of excessively high amplitude of the resonance signal) via the connection 19B to the processing device 18B, so that the processing device 18B can suitably adjust the signal amplifier 14.

## Claims

1. A magnetic resonance device for determining a nuclear magnetization distribution in a region of an object, which device comprises:
a) means (2) for generating a steady, uniform magnetic field (H₀);
b) means (10, 12) for generating RF electromagnetic radiation (P₁, P₂) in order to generate magnetic resonance signals (E);
c) means (4) for generating at least one phase encoding gradient magnetic field (Gₓ) and a readout gradient field (G_{y}) with adjustable gradient directions for influencing the magnetic resonance signals (E),
d) a detection chain comprising a signal amplifier (14) for detecting, amplifying and sampling the resonance signals during a measuring period, and an analog-to-digital converter (18C) which is connected thereto;
e) processing means (18) for processing the sampled resonance signals;
f) control means (18B) for controlling at least the means specified sub b) to e), resonance signals being conditioned during a preparation period preceding the measuring period, the control means (18B) supplying the means specified sub c) with control signals for adjusting the strength and/or the duration of at least one phase encoding gradient magnetic field (Gₓ) so that the integral of the strength of the phase encoding gradient magnetic field over the preparation period is different for each measuring cycle; and
g) adjusting means for adjusting the gain of the amplifier (14) for different resonance signals (E) and means to correct said detected resonance signals for the actual gain, the gain can be selected from a first range or a second range, the values in the first range being lower than these in the second range which are such that the noise factor of the detection chain and the analog-to-digital converter (18C) connected thereto is substantially independent of the gain,
characterized in that the adjusting means are arranged so that for high values of said integral the gain is selected as a value in the second range in which a resonance signal (E) received or to be received does not cause overdriving of the detection chain, that the gain is selected as a value in the first range for lower values of said integral and that the gain is switched to a lower value yet should overdriving occur.

2. A magnetic resonance device as claimed in Claim 1, characterized in that the signal amplifier (14) has only two gain settings.

3. A magnetic resonance device as claimed in Claim 1 or 2, characterized in that for a measuring cycle for determining a data set having an index number (|n|) in excess of a predetermined value a higher signal amplifier gain can be adjusted.

4. A magnetic resonance device as claimed in Claim 1 or 2, characterized in that the processing device (18) comprises programmed means for repeating a measuring cycle and for adjusting a lower amplifier gain in the detection chain after reception of an overflow signal from the analog-to-digital converter (18C).

5. A magnetic resonance device as claimed in Claim 1 or 2, characterized in that the processing and control unit (18) is programmed so that measuring cycles executed with a low gain are repeated, the resonance signals of these measuring cycles which have passed the analog-to-digital converter (18C) being averaged.

6. A magnetic resonance device as claimed in Claim 1, 2 or 3, characterized in that the processing unit (18) comprises an amplifier setting register in which gain settings are stored which are determined on the basis of at least one resonance signal (E) generated during a test measuring cycle executed prior to a measurement.

## Revendications

1. Appareil à résonance magnétique pour déterminer une distribution de la magnétisation nucléaire dans une région d'un objet, lequel appareil comprend :
a) des moyens (2) pour engendrer un champ magnétique statique uniforme (H₀);
b) des moyens (10, 12) pour engendrer un rayonnement électromagnétique de radiofréquence (P₁, P₂) en vue de produire des signaux de résonance magnétique (E);
c) des moyens (4) pour engendrer au moins un champ magnétique de gradient de codage de phase (Gₓ) et un champ de gradient de lecture (G_{y}) avec des directions de gradient réglables pour influencer les signaux de résonance magnétique (E);
d) une chaîne de détection comprenant un amplificateur de signaux (14) pour détecter, amplifier et échantillonner des signaux de résonance pendant une période de mesure, et un convertisseur analogique-numérique (18C) qui y est connecté;
e) des moyens de traitement (18) pour traiter les signaux de résonance échantillonnés;
f) des moyens de commande (18B) pour commander au moins les moyens spécifiés sous b) à e), les signaux de résonance étant conditionnés pendant une période de préparation précédant la période de mesure, les moyens de commande (18B) transmettant aux moyens spécifiés sous c) les signaux de commande pour régler l'intensité et/ou la durée d'au moins un champ magnétique de gradient de codage de phase (Gₓ) de façon que l'intégrale de l'intensité du champ magnétique de gradient de codage de phase sur la période de préparation soit différente pour chaque cycle de mesure, et
g) des moyens d'ajustement pour régler le gain de l'amplificateur (14) pour différents signaux de résonance (E) et des moyens pour corriger ces signaux de résonance détectés en fonction du gain réel, le gain pouvant être sélectionné dans un premier intervalle ou dans un second intervalle, les valeurs du premier intervalle étant inférieures à celles du second intervalle qui sont telles que le facteur de bruit de la chaîne de détection et du convertisseur analogique-numérique (18C) qui y est connecté soit sensiblement indépendant du gain,
caractérisé en ce que les moyens d'ajustement sont agencés de façon que pour les valeurs élevées de cette intégrale le gain soit sélectionné comme valeur dans le second intervalle dans lequel un signal de résonance (E) reçu ou à recevoir n'entraîne pas de suramplification de la chaîne de détection, que le gain soit sélectionné comme valeur dans le premier intervalle pour les valeurs inférieures de cette intégrale et que le gain soit commuté vers une valeur inférieure au cas où la suramplification aurait lieu.

2. Appareil à résonance magnétique suivant la revendication 1, caractérisé en ce que l'amplificateur de signaux (14) ne comprend que deux réglages du gain.

3. Appareil à résonance magnétique suivant la revendication 1 ou 2, caractérisé en ce que pour un cycle de mesure visant à déterminer un jeu de données ayant un indice (|n|) supérieur à une valeur prédéterminée, un gain plus élevé de l'amplificateur de signaux peut être réglé.

4. Appareil à résonance magnétique suivant la revendication 1 ou 2, caractérisé en ce que les moyens de traitement (18) comprennent des moyens programmés pour répéter un cycle de mesure et pour régler un gain plus faible de l'amplificateur dans la chaîne de détection après réception d'un signal de dépassement de capacité émanant du convertisseur analogique-numérique (18C).

5. Appareil à résonance magnétique suivant la revendication 1 ou 2, caractérisé en ce que les moyens de traitement et de commande (18) sont programmés de façon que les cycles de mesure exécutés avec un gain faible soient répétés, les signaux de résonance de ces cycles de mesure qui sont passés par le convertisseur analogique-numérique (18C) faisant l'objet d'un moyennage.

6. Appareil à résonance magnétique suivant la revendication 1, 2 ou 3, caractérisé en ce que les moyens de traitement (18) comprennent un registre de réglage d'amplificateur dans lequel sont mémorisés des réglages de gain qui sont déterminés sur la base d'au moins un signal de résonance (E) engendré pendant un cycle de mesure d'essai exécuté avant une mesure.

## Patentansprüche

1. Kernresonanzeinrichtung zum Bestimmen einer Kernmagnetisierungsverteilung in einem Gebiet eines Objekts, welche Einrichtung folgendes umfaßt:
a) Mittel (2) zum Erzeugen eines stationären, homogenen Magnetfeldes (H₀);
b) Mittel (10, 12) zum Erzeugen elektromagnetischer HF-Strahlung (P₁, P₂), um Kernresonanzsignale (E) zu erzeugen;
c) Mittel (4) zum Erzeugen zumindest eines Phasencodierungsgradientenmagnetfeldes (Gₓ) und eine Auslesegradientenfeldes (G_{y}) mit einstellbaren Gradientenrichtungen zum Beeinflussen der Kernresonanzsignale (E);
d) eine Detektorkette mit einem Signalverstärker (14) zum Detektieren, Verstärken und Abtasten der Resonanzsignale während einer Meßzeit sowie einen daran angeschlossenen Analog-Digital-Umsetzer (18C);
e) Verarbeitungsmittel (18) zum Verarbeiten der abgetasteten Resonanzsignale;
f) Steuerungsmittel (18B) zum Steuern zumindest der unter b) bis e) spezifizierten Mittel, wobei Resonanzsignale in einer der Meßzeit vorangehenden Vorbereitungszeit konditioniert werden, wobei die Steuerungsmittel (18B) den unter c) spezifizierten Mitteln Steuersignale zum Einstellen der Stärke und/oder der Dauer zumindest eines Phasencodierungsgradientenmagnetfeldes (Gₓ) zuführen, so daß für jeden Meßzyklus das Integral der Stärke des Phasencodierungsgradientenmagnetfeldes über die Vorbereitungszeit verschieden ist, und
g) Einstellmittel zum Einstellen der Verstärkung des Verstärkers (14) für verschiedene Resonanzsignale (E) und Mittel zum Korrigieren der genannten detektierten Resonanzsignale hinsichtlich der tatsächlichen Verstärkung, wobei die Verstärkung aus einem ersten Bereich oder einem zweiten Bereich gewählt werden kann, wobei die Werte in dem ersten Bereich niedriger sind als die in dem zweiten Bereich, die derart sind, daß der Rauschfaktor der Detektorkette und des daran angeschlossenen Analog-Digital-Umsetzers (18C) nahezu von der Verstärkung unabhängig ist,
dadurch gekennzeichnet, daß die Einstellmittel so ausgebildet sind, daß die Verstärkung für hohe Werte des Integrals als ein Wert im zweiten Bereich gewählt wird, in dem ein empfangenes oder zu empfangendes Resonanzsignal keine Übersteuerung der Detektorkette bewirkt, daß die Verstärkung für niedrigere Werte des Integrals als ein Wert im ersten Bereich gewählt wird und daß die Verstärkung, falls doch Übersteuerung auftreten sollte, auf einen niedrigeren Wert geschaltet wird.

2. Kernresonanzeinrichtung nach Anspruch 1, dadurch gekennzeichnet, daß der Signalverstärker (14) nur zwei Verstärkungseinstellungen aufweist.

3. Kernresonanzeinrichtung nach Anspruch 1 oder 2, dadurch gekennzeichnet, daß für einen Meßzyklus zum Bestimmen eines Datensatzes mit einer über einem vorgegebenen Wert liegenden Indexziffer (|n|) eine größere Verstärkung des Signalverstärkers einstellbar ist.

4. Kernresonanzeinrichtung nach Anspruch 1 oder 2, dadurch gekennzeichnet, daß die Verarbeitungseinrichtung (18) programmierte Mittel zum Wiederholen eines Meßzyklus und zum Einstellen einer niedrigeren Verstärkung eines Verstärkers in der Detektorkette nach dem Empfang eines Überlaufsignals aus dem Analog-Digital-Umsetzer (18C) umfaßt.

5. Kernresonanzeinrichtung nach Anspruch 1 oder 2, dadurch gekennzeichnet, daß die Verarbeitungs- und Steuereinheit (18) so programmiert ist, daß bei einer niedrigeren Verstärkung durchgeführte Meßzyklen wiederholt werden, wobei die Kernresonanzsignale dieser Meßzyklen, die den Analog-Digital-Umsetzer (18C) durchlaufen haben, gemittelt werden.

6. Kernresonanzeinrichtung nach Anspruch 1, 2 oder 3, dadurch gekennzeichnet, daß die Verarbeitungseinheit (18) mit einem Verstärkereinstellregister versehen ist, in dem Verstärkungseinstellungen gespeichert sind, die anhand zumindest eines bei einem vor einer Messung durchgeführten Testmeßzyklus erzeugten Resonanzsignals (E) bestimmt werden.
